# EUROPEAN PATENT SPECIFICATION

(11) **EP 3 779 487 B1**
(45) Date of publication and mention of the grant of the patent: **19.07.2023**
(21) Application number: 19191633.7
(22) Date of filing: 14.08.2019
(51) Int. Cl.: G01R 33/00, G01R 33/025, G01R 33/09, G01D 5/14, G01R 33/038

(54) **ASSEMBLY AND METHOD FOR DETERMINING THE STRENGTH OF A MAGNETIC STRAY FIELD**
ANORDNUNG UND VERFAHREN ZUR BESTIMMUNG DER STÄRKE EINES MAGNETISCHEN STREUFELDES
ENSEMBLE ET PROCÉDÉ POUR DÉTERMINER LA RÉSISTANCE D'UN CHAMP MAGNÉTIQUE PARASITE

(43) Date of publication of application: 17.02.2021
(73) Proprietor: TE Connectivity Sensors Germany GmbH, 44227 Dortmund (DE)
(72) Inventor: BARTOS, Axel, 45731 Waltrop (DE); MEISENBERG, Armin, 44227 Dortmund (DE)
(74) Representative: Grünecker Patent- und Rechtsanwälte PartG mbB

(56) References cited:
- US-A1- 2018 087 889
- US-A1- 2018 238 711
- US-A1- 2019 178 684

## Description

### FIELD

The present invention relates to an assembly for determining the strength of a magnetic stray field of an external disturbing magnetic field in a magnetic senor detecting a rotational angle of a rotary member and the corresponding method for determining the strength of the magnetic stray field.

Generally, magnetoresistive sensors (also referred to in this application as magnetic sensors) measure the direction of magnetic fields. Such arrangements and methods find use in the art of determining angles and positions in the context of magnetic field sensors, particularly those utilizing magnetoresistive effects.

The sensors make use of the magnetoresistive effect, which is the tendency of a material (e.g. ferromagnetic) to change the value of its electrical resistance in an externally applied magnetic field. In particular, multicomponent or multilayer systems (e.g. magnetic tunnel junctions), giant magnetoresistance (GMR), tunnel magnetoresistance (TMR), colossal magnetoresistance (CMR), and extraordinary magnetoresistance (EMR) observe magnetoresistance, while the anisotropic magnetoresistive effect (AMR) needs only one layer to occur.

The externally applied field can be generated by a permanent magnet, which is an object made from a material that is magnetized creating its own persistent magnetic field. In the case of a magnetic sensor, detecting a rotational angle of a rotary member, the permanent magnet is attached to the rotary member connected to a rotating axis and the sensor element is opposing the magnet. Since the field induced by the permanent magnet is time invariant, the direction of the magnetic field is only determined by the orientation of the rotating component relative to the sensing element.

Magnetic sensors provide an outstanding angle accuracy as well as a high robustness against challenging environmental conditions and play an important role in various applications such as manufacturing and transportation applications. In more detail, magnetoresistive angle sensors are important components because of their low intrinsic measurement error and high stability. Additionally, the favorable temperature characteristic as well as the robustness against harsh environmental conditions leads to the relevance of magnetoresistive (MR) sensors in many important applications. Exemplifying the automotive domain, MR angular sensors are used in electronic power steering, wiper or throttle valve systems as well as engine applications. However, disturbing fields interfering the field of the permanent magnet can significantly influence the measurement, which may have effects on accuracy of the measurement and the safety of the application.

In particular, future sensors must be robust up to 3 kA/m disturbing fields. For automotive applications a magnetoresistive sensor must conform the norm ISO11452-8 [ISO 11452-8:2015-06 *Road vehicles* - *Component test methods for electrical disturbances from narrowband radiated electromagnetic energy* - *Part 8: Immunity to magnetic fields*]*.* In particular, this standard requires in annex "A.2.3 External field", Table A.2, at Test level IV and 0 Hz a sensor robustness of 3 kA/m.

The robustness against disturbing fields can be addressed, for example, by shielding external magnetic fields or by using field gradients for the angular measurement. Such solutions, however, can increase the system costs significantly. To minimize the impact of stray fields with a high magnitude, unacceptable large and strong disc or block magnets based on expensive materials have to be used.

According to an alternative solution, the disturbing fields can be detected and corrected. A need remains, however, for an assembly for determining accurately the influence of a magnetic stray field in a magnetic sensor detecting a rotational angle of a rotary member. Advantageously, the assembly can be fabricated economically. Further, the assembly can be designed small size to fit space requirements of the desired application.

US 2018/238711 A1 describes an angle sensor may include a first sensing element to provide a first set of output signals associated with a magnetic field produced by a rotatable magnet. The first sensing element may be arranged at a first distance from a surface of the rotatable magnet along a given direction, and may be configured to operate in a non-saturated mode.

US 2018/087889 A1 describes a magnetic angle sensor device and a method for operating such device is provided. The magnetic angle sensor device includes a shaft rotatable around a rotation axis; a magnetic field source coupled to the shaft; a first magnetic angle sensor configured to generate a first signal that represents a first angle based on a first diametric magnetic field from the magnetic field source applied to the first magnetic angle sensor; a second magnetic angle sensor configured to generate a second signal that represents a second angle based on a second diametric magnetic field from the magnetic field source applied to the second magnetic angle sensor; and a combining circuit configured to determine a combined rotation angle based on the first signal and on the second signal.

US 2019/178684 A1 describes a system includes a magnetic sense element for detecting an external magnetic field along a sensing axis and a magnetic field source proximate the magnetic sense element for providing an auxiliary magnetic field along the sensing axis.

At least one of these objectives is solved by the subject matter of the independent claims. Advantageous embodiments of the present invention are the subject matter of the dependent claims

The invention being defined only in the appended independent claims.

Embodiments and/or examples mentioned in the following description that do not necessarily fall under the scope of the appended claims are to be construed as comparative examples useful for understanding the present invention.

In particular, the present invention is based on the idea to provide an assembly for determining the strength of a magnetic stray field influence in a magnetic sensor detecting a rotational angle of a rotary member. The assembly comprises a permanent magnet for generating a magnetic field, the permanent magnet being arranged on the rotary member so that at the sensor position a parallel field, perpendicular to the rotation axis is created. For example, the magnetic poles extend in a radial direction from an axis of rotation about which the rotary member rotates. Further, the assembly comprises a first channel comprising a first magnetic sensing element positioned on the axis of rotation, the first channel being configured to provide first angular data. Further, the assembly comprises a second channel comprising a second magnetic sensing element positioned on the axis of rotation, the second channel configured to provide second angular data, wherein the second magnetic sensing element is spaced in the direction of the axis of rotation by a predetermined value z from the first magnetic sensing element. Further, the assembly comprises an induction channel comprising an electromagnetic coil wound around the axis of rotation, the induction channel being adapted to pass an electric current. Further, the assembly comprises a processor configured to compute a first field strength based on a plurality of first angular data received by the first channel and a value of the electric current passed through the induction channel. The processor further being configured to compute a second field strength based on a plurality of second angular data received by the second channel and the value of the electric current passed through the induction channel. The processor further being configured to compute the magnetic stray field influence by comparing the first field direction and field strength with the second field direction and field strength. Finally, the first magnetic sensing element and the second magnetic sensing element comprises three voltage divider.

In more detail, the magnetic field generated by the permanent magnet is determined by the distance to the sensing elements. In particular, the first sensor being connected by the first channel to the processor is used to determine a first field strength and field direction of the permanent magnet field at a first distance to the magnet, wherein the first sensor is arranged on the axis of rotation. Additionally, the second sensor being connected by the second channel to the processor, the second sensor also being arranged on the axis of rotation, is used to determine a second field strength and direction of the permanent magnet field at a second distance to the magnet. Thus, both sensors determine angular data representing the same angle of rotation of the rotary member.

Further, the magnetic field generated by the permanent magnet is interfered with an excitation field of the coil in order to determine the field strength in the plane of the first sensor and in the plane of the second sensor. As the planar coil is wound around the axis of rotation, the excitation field is always partially orthogonal to the magnetic field generated by the permanent magnet. This enables a compact design and reducing the computational effects for determining the field strength of the permanent magnet. Thus, both sensors determine a magnetic field strength, which is different due to the different distance of each sensor to the permanent magnet. In other words, the density of the filed vectors of the magnetic field of the permanent magnet is different in the sensor plane of the first sensor compared to the density of the filed vectors of the magnetic field of the permanent magnet in the sensor plane of the second sensor. Advantageously, each sensor comprises an integrated coil in order to determine the local field strength at each sensor by generating the well known coil field.

In other word, each sensor measures the angular position of the permanent magnet with respect to its sensor plane twice, once the angular position is detected with a first excitation field and once the angular position is detected with a second excitation field. The first excitation field is different from the second excitation field. Thus, the processor can determine the field strength generated by the permanent magnet in the plane of the first sensor and in the plane of the second sensor. Advantageously, the first excitation field is equal in its amount to the second excitation field, however, opposite in the direction of the field. For example, the value of electric current passed through the induction channel and the resulting power dissipation being equal for the both measurements, however, the direction being different.

In an external magnetic disturbing field, its disturbing influence increases with decreasing field strength at the sensor and vice versa. This leads to a difference in the measured field angles at both sensors. Measuring the magnetic field strength generated by the permanent magnet at two positions, wherein at these two positions the field density is different and measuring at both positions the field angle, enables to calculate the magnetic stray field influence generated by a disturbing source that is interfering the field of the permanent magnet, and thus, the influence of the stray field can be compensated. Advantageously, it is assumed that the distance between the disturbing source and the assembly is larger than the dimensions of the assembly. This assumption generally holds particularly true if the sensor assembly is compact and thus the field vectors of the magnetic stray field are homogenously, i.e. the field vectors of the stray field are parallel and the density of said field vectors is constant at the positions of both sensors. Based on this assumption, the strength of the disturbing source can be easily calculated. In more detail, the both sensors measure two different resulting magnetic fields, namely the field generated by the assembly, i.e. the field of the permanent magnet and the excitation field of the coil, which is predefined and the interfering stray field generated by the disturbing source, which strength can be calculated based on the above assumption.

According to one embodiment, the first magnetic sensing element consists of three voltage dividers and the second magnetic sensing element consists of three voltage dividers. Each voltage divider forms a half bridge. The main advantageous of three voltage dividers is an optimized arrangement, namely that the size of the sensor in the dimension of the sensor plane is reduced compared to a sensor consisting of an even number of voltage dividers. Furthermore, three voltage divider provide a spare measurement signal.

In other words, sensors having three voltage dividers provide the similar advantageous as a three-wire three-phase circuit compared to an equivalent two-wire two-phase circuit at the same line to ground voltage. In particular, less sensor size is needed to receive a given amount of signal strength.

Additionally, a reduced size of the sensing element in the plane perpendicular to the axis of rotation is advantageous as thus the requirements for the magnetic field generated by the permanent magnet can be relaxed. In more detail, for measuring the angle requires that the field of the permanent magnet is homogenous in the sensor plane. However, for determining the strength of the field of the disturbing source, the magnetic field strength generated by the permanent magnet has to be divergent (also referred to as inhomogeneous) along the axis of rotation. Thus, a reduced sensor size in a plane perpendicular to the axis of rotation is advantageous for an assembly that can detect and correct the field of a disturbing source. In particular, thus also the volume requirements for the magnet can be relaxed.

Advantageously, each voltage divider comprises resistors formed by magneto resistive layers arranged in a sensor plane with opposing resistance changes in the magnetic field. Thus, the measured amplitude can be increased thereby improving the measurement. Thus, the sensor size in a plane perpendicular to the axis of rotation can be optimized.

Even more advantageously, each voltage divider comprises a first conducting path forming a first resistor and a second conducting path supplying an inverse resistance change compared to the first conducting path forming a second resistor. Thus, the phase angle between the two resistors forming one half bridge is optimized thereby increasing the signal strength and thereby further reducing the sensor size in a plane perpendicular to the axis of rotation. For example, the first conducting path forming the first resistor and the second conducting path forming the second resitor are arranged perpendicular.

Further, three half bridges allow a minimum coil design, thereby further minimizing the size of the sensor in the sensor plane. In particular, according to an advantageous embodiment the voltage divider are evenly distributed, namely two abutting voltage dividers are separated by an angle of 120° thus increasing the sensitive sensor area. Additionally or alternatively, the windings of the electromagnetic coil form triangles. Thus, the sensor size in a plane perpendicular to the axis of rotation is further reduced.

According to an advantageous embodiment, a first electromagnetic coil and the first sensing element are fabricated as an integrated circuit forming a first die and a second electromagnetic coil and the second sensing element are fabricated as an integrated circuit forming a second die. Fabricating one coil together with one sensing element in one die reduces the number of parts. Thereby the number of parts that have to be aligned after fabrication is reduced, alignment tolerances can be easily met, and the measurement accuracy is increased.

In order to increase the range for measuring disturbing filed, the accuracy of the magnetic sensor have to be increased. Thus, an integrated fabrication is advantageous for an assembly that can detect and correct the field of a disturbing source. Additionally, the volume requirements for the magnet can be relaxed.

Even more advantageously, the second die is stacked atop the first die packaged in an integrated circuit package. Two stacks in an integrated package further reduce the parts to be aligned, thus reducing alignment errors, thus increasing the range for measuring disturbing fields and relaxing the volume requirements for the magnet.

Preferably, the integrated circuit of the first sensing element has a distance z of 0.2 to 0.8 mm to the integrated circuit of the second sensing element. Even more preferably, the first sensing element has a distance z of 0.4 mm to the integrated circuit of the second sensing element.

Additionally, a top contacting surface of the integrated circuit package is facing the permanent magnet and a bottom contacting surface of the integrated circuit package is facing a circuit board. This enables a compact design of the integrated circuit package and additionally increases the distance between the sensor planes. Thus, the divergent field of the permanent magnet along the axis of rotation can be optimally used for measuring the strength of the magnetic stray field and additionally relaxing the parts to be aligned.

Preferably the top contacting surface having a distance of 0.2 to 0.8 mm to the bottom contacting surface. Even more preferably, the top contacting surface having a distance of 0.4 mm to the bottom contacting surface.

Additionally or alternatively, a first contact arrangement of the integrated circuit package is contacted to a lead frame by a first technique, preferably by wire bonding, and a second contact arrangement of the integrated circuit package is contacted by a second technique, preferably by flip chip technology. This is a suitable technology to integrate two stacked sensor chips with defined vertical distance between the sensing structures together in one package.

Advantageously, the integrated circuit package, the circuit board and the processor are covered by a housing, preferably a wall of the housing arranged atop the first die having a thickness of typically 0,05 to 0,5 mm. Thus, the number of parts can be further reduced.

Additionally or alternatively, the permanent magnet has a short side and a long side, wherein the long side is longer than the short side. Preferably, the long side of the permanent magnet is 2 to 20 times longer than the short side. In other words, the magnet is essential in the form of a rectangular cuboid forming for example a bar magnet. Thus, the volume of the magnet for generating the magnetic field, having a high divergence along the axis of rotation and being homogeneous in the sensor plane, is reduced.

Even more advantageously, the poles of the permanent magnet are formed at opposite ends of the short side. In other words, the poles of the magnet are radial extending from the axis of rotation. The surface of the rectangular cuboid forming the opposing poles are closer to the axis of rotation than the surfaces of the rectangular cuboid comprising opposing poles.

Additionally or alternatively, the permanent magnet has a recess at a surface facing the first magnetic sensing element. In other words, the magnet has is U-shaped. However, in contrast to a horseshoe magnet the opposing poles are also U-shaped. Such a magnet is particularly advantageous to generate a high gradient in the direction extending from the legs of the U-shaped magnet and at the same time having a nearly homogeneous field parallel to the short connecting arm of the U-shaped magnet. Thus, the volume of the magnet can be further reduced and the volume requirements for the magnet can be more easily met. Advantageously, the magnet has a height of 1 to 5 mm, preferably 3 mm, the height is along the axis of rotation. Additionally or alternatively, the magnet has a width of 1 to 5 mm, preferably 3.5 mm, the width being the direction of the magnetization. Additionally or alternatively, the magnet has a length of 5 to 10 mm, preferably 7 mm. Additionally or alternatively, the recess has a height of 0.1 to 1 mm, preferably 0.5 mm. Additionally or alternatively, the recess has a length of 1 to 4.5 mm, preferably 4 mm.

Additionally or alternatively, the permanent magnet comprises rare earth materials. Thus, the volume of the magnet can be further reduced and the volume requirements for the magnet can be more easily met. On the other hand, the field strength at the sensor elements can be enhanced in order to reduce the influence of external disturbing fields on the angular measurement.

The present invention also relates to a method for sensing the strength of a magnetic stray field in a magnetic sensor detecting a rotational angle of a rotary member with an assembly according an assembly above discussed. The method comprises the steps of:
- computing, by a processor, a first field strength (Ht) based on a plurality of first angular data received by a first channel and a value (Icoil+, Icoil-) of an electric current passed through an induction channel,
- computing, by the processor, a second field strength (Hb) based on a plurality of second angular data received by a second channel and a value (Icoil+, Icoil-) of the electric current passed through the induction channel,
- computing, by the processor, the disturbing influence of the magnetic stray field by comparing the first field strength with the second field strength and the first measured field angle with a second measured field angle

Advantageously, the first field strength is computed by passing two different values of the electric current through the induction channel and receiving different sensor output voltages for the two different values of the electric current, respectively; and the second field strength is computed by passing two different values of the electric current through the induction channel and receiving different sensor output voltages for the two different values of the electric current, respectively.

The accompanying drawings are incorporated into the specification and form a part of the specification to illustrate several embodiments of the present invention. These drawings, together with the description, serve to explain the principles of the invention. The drawings are merely for the purpose of illustrating the preferred and alternative examples of how the invention can be made and used, and are not to be construed as limiting the invention to only the illustrated and described embodiments.

Further features and advantages will become apparent from the following more particular description of the various embodiments of the invention as illustrated in the accompanying drawings, in which like references refer to like elements, and wherein:
- **FIG. 1**: is a schematic view of an assembly for determining and compensating a magnetic stray field influence in a magnetic sensor detecting a rotational angle of a rotary member;
- **FIG. 2**: is a vector diagram of the magnetic fields;
- **FIG. 3**: is a schematic view of an integrated circuit comprising an AMR-sensing element and a coil;
- **FIG. 4**: is a detailed view of the coil of the integrated circuit of Fig. 3;
- **FIG. 5**: is a detailed view of the sensing element of the integrated circuit of Fig. 3;
- **FIG. 6**: is a schematic circuit diagram of the integrated circuit of Fig. 3;
- **FIG. 7**: is a vector diagram of the magnetic fields generated by the permanent magnet and the excitation field generated by the coil;
- **FIG. 8**: is another view of the vector diagram of the magnetic fields of Fig. 7;
- **FIG. 9**: is schematic view of an integrated circuit package according to a first embodiment;
- **FIG. 10**: is schematic view of an integrated circuit package according to a second embodiment;
- **FIG. 11**: is schematic side view of a permanent magnet and an integrated circuit package; and
- **FIG. 12**: is bottom view of Fig. 11.

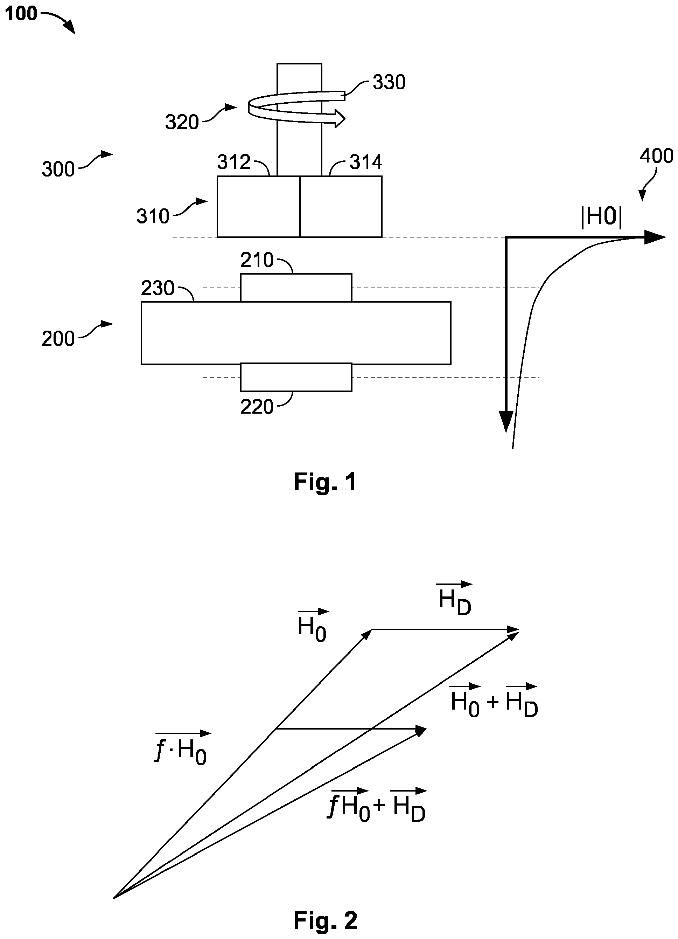

The present invention will now be explained in more detail with reference to the Figures. Referring to Fig. 1 a schematic view of an assembly 100 for determining the strength of a magnetic stray field in a magnetic sensor 200 detecting a rotational angle of a rotary member 300 is shown.

The magnetic sensor 200 comprises a first magnetic sensing element 210 and a second magnetic sensing element 220. The first magnetic sensing element 210 and the second magnetic sensing element 220 are connected to a circuit board 230, for example a printed circuit board.

The rotary member 300 comprises a permanent magnet 310 attached to a rotating shaft 320. The rotary member rotates around an axis of rotation, indicated by arrow 330. The permanent magnet is magnetized in a direction extending from the axis of rotation thereby forming a magnetic south pole 312 and a magnetic north pole 314.

The first and second sensing element 210, 220 and the permanent magnet are arranged on the axis of rotation. The first and second sensing element 210, 220 are extending in a plane perpendicular to the axis of rotation. The first and second sensing element 210, 220 are arranged apart from the magnet 310 at a predetermined distance and the first sensing element 210 is spaced apart from the second sensing element 220 at a predetermined distance.

The resulting magnetic field H0 is indicated by diagram 400. The amount of the magnetic field |H0| of the permanent magnet is decreasing in the direction towards the first and second sensing element 210, 220.

Now referring to Fig. 2, showing a vector diagram of the magnetic fields, the influence of an interfering disturbing magnetic stray field HD is shown. The vector H0 indicates the magnetic field of the permanent magnet in the plane of the first sensing element. The vector f x H0 indicates the magnetic field of the permanent magnet in the plane of the second sensing element. The disturbing field is indicated by the vector HD. In particular, this diagram is based on the assumption that the distance between the assembly and the source of the disturbing field is greater than the dimensions of the assembly, in particular the distance between the permanent magnet and the second sensing element. Thus it can be assumed that the direction and the strength of the field of the disturbing source is homogeneous within the assembly. In general, this assumption holds true. However, if this assumption would not hold true, the strength of the disturbing field may be determined based on more advanced calculations.

By measuring the strength of the interfering field fxH0 +HD with the second sensing element and measuring the interfering field H0 plus HD with the first sensing element the strength of the influence of the interfering field of the disturbing source can be computed and the influence can be compensated for the angle measurement.

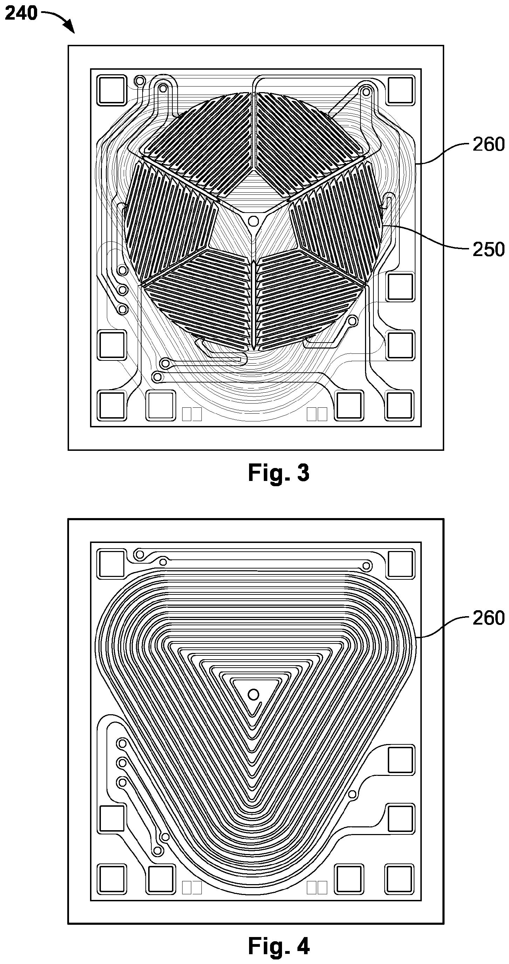

Now referring to Fig. 3, showing a schematic view of an integrated circuit 240 comprising an AMR-sensing element 250 and a coil 260. The sensing element 250 is arranged in one layer of the integrated circuit and in another abutting layer the coil 260 is arranged. According to one embodiment, each of the first sensing element 210 and the second sensing element 220 is formed by the integrated circuit shown in Fig. 3, thereby forming a first die and a second die.

Now the coil 260 according to an advantageous embodiment is described in detail. In particular, Fig. 4 shows a detailed view of the layer comprising the coil 260 of the integrated circuit of Fig. 3. The coil 260 has a plurality of windings arranged around the axis of rotation. The coil 260 contacts by a first contacting point the center of the integrated circuit. The windings of the coil are arranged spirally around the contacting point, wherein each winding generally follows the shape of a triangle. The windings of the coil are arranged in a layer of the integrated circuit. According to the shown embodiment of the coil, the corners of each triangle forming a winding are rounded, thereby minimizing the space requirements of the coil.

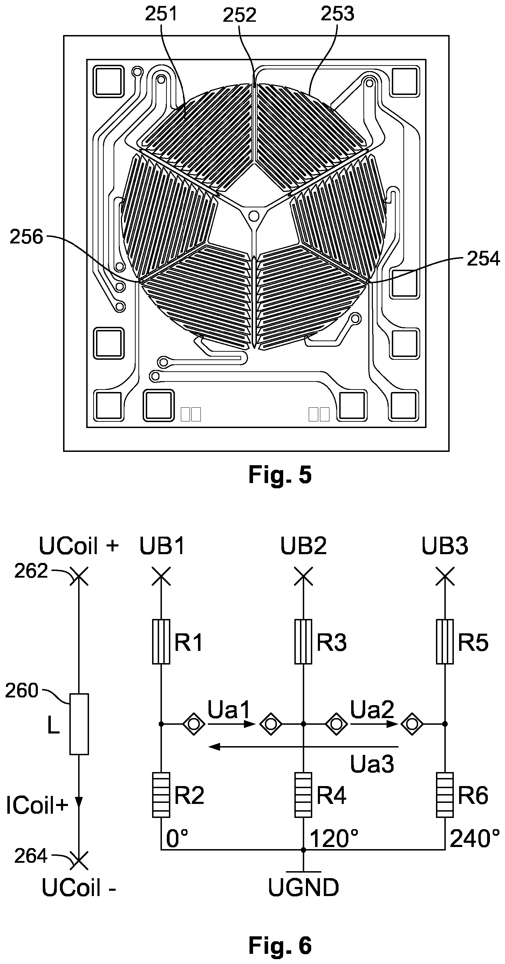

Further, with reference to Fig. 5 an arrangement of the sensing element of the integrated circuit shown in Fig. 3 is shown. The sensing element comprises three voltage dividers 252, 254, 256. The three voltage dividers 252, 254, 256 are arranged in a plane of the integrated circuit. The voltage dividers 252, 254, 256 are symmetrically distributed in one layer of the integrated circuit. The angle between two abutting voltage dividers is 120°.

The three voltage dividers 252, 254, 256 are formed similarly. Exemplary, voltage divider 252 is described in detail. Voltage divider 252 comprises a first resistor 251 and a second resistor 253. A first end of the resistors 251, 253 is interconnected and the second end of the resistors 251, 253 are connected to contact pads, which enable the electrical connection to supply voltage and signal evaluation unit.

Magnetoresistive strips arranged in the layer form the resistors 251, 253. The magnetoresistive strips are connected, forming conducting paths. Thus, the field direction of the permanent magnet can be measured.

In particular, each path meanders from a central portion of the integrated circuit to an external portion of the integrated circuit. The path is formed by longer parallel sections and shorter sections that are shorter that the longer sections. The shorter sections are generally extending in the direction from the central portion of the integrated circuit to the extent a portion of the integrated circuit. Parallel sections of a first resistor 251 are arranged perpendicular to parallel sections of a second resistor 253. Resistors forming one voltage divider that are arranged substantially perpendicular enable the measurement of the direction of the magnetic field as they react with opposing phases to changes of the magnetic field, thereby generating the measurement signal.

As shown in Fig. 3, the arrangement of the coil 260 and the arrangement of the three voltage dividers forming the sensing element 250 is optimized so that the space requirements for the integrated circuit are minimized.

Further, with reference to Fig. 6 a schematic circuit diagram of the integrated circuit of Fig. 3 is shown. An induction channel comprises the coil 260 that is connected to a first contacting node 262 and the second contacting node 264. By the direction of the current applied to the introduction channel the direction of the magnetic field can be influenced. In particular, the current may be Icoil+ or in the opposing direction with Icoil-.

As further shown in Fig. 6, a measurement channel comprises the three voltage dividers. Each voltage divider comprises a first end, which is connected to ground, a second end, which is connected to Ub1, Ub2 or Ub3, and a central tap. As already explained with reference to Fig. 5, the angle between two abutting voltage dividers is 120°. The central taps of two abutting voltage dividers, each of the voltage dividers forming a half bridge, are interconnected thereby forming a full bridge, in particular a Wheatstone bridge, with output voltage Ua1, Ua2, and Ua3. Thus, based on the output voltages, the angle of rotation can be determined.

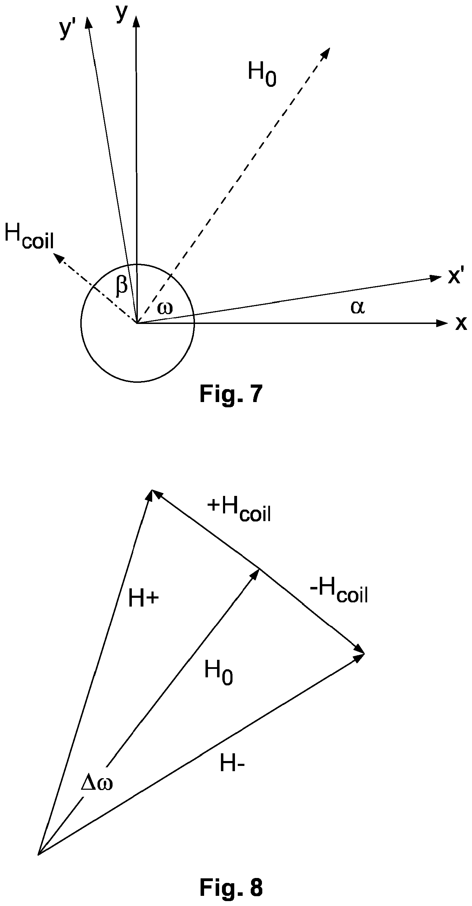

Further, Fig. 7 shows a general vector diagram of the magnetic fields generated by the permanent magnet and the excitation field generated by the coil 260. The angular position ω is given by the components x and y of the magnetic field H0 in the sensing plane. Using the coil 260, which generates the field Hcoil, an additional field is induced in the sensing plane and the measured angle changes. As Hcoil is orthogonal to H0 the resulting field strength of the permanent magnet in the sensing plane can be calculated.

Fig. 8 shows a vector diagram of the magnetic fields measured by the sensing element according to an advantageous embodiment. The electric current is passed in opposite directions through the inducing channel, namely by current Icoil+ and Icoil-, so that the induced field is once +Hcoil and once -Hcoil. Consequently, the effect of the induced field by the coil is maximized and the measurement to determine the field strength of the permanent magnet is optimized.

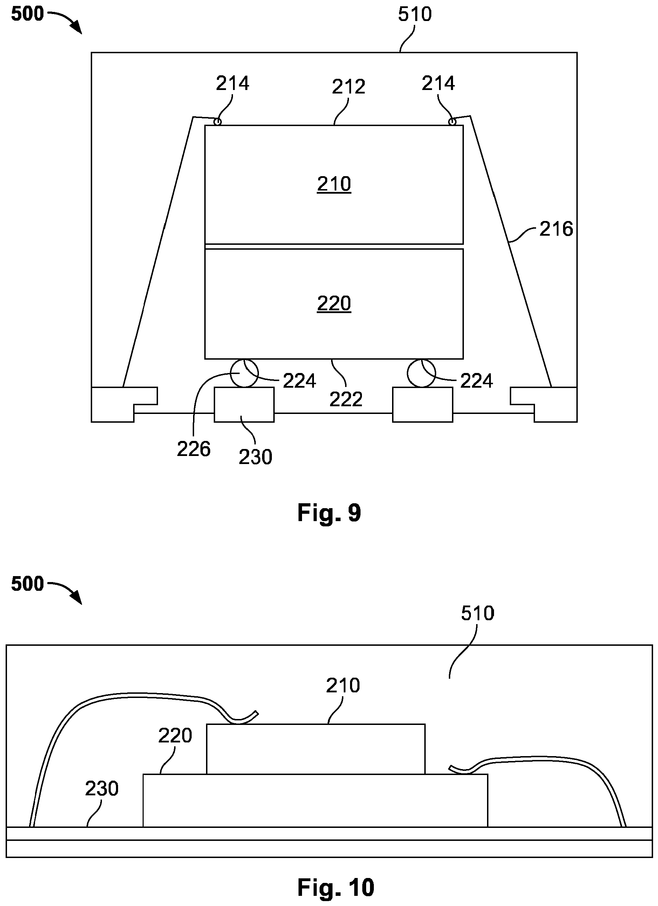

Fig. 9 shows a schematic view of an integrated circuit package 500 according to an advantageous embodiment. The integrated circuit package 500 comprises a circuit board 230, for example a lead frame 230, a first die with the first sensing element 210, and a second die with the second sensing element 220. The integrated circuit package 500 is covered by a housing 510.

As shown further in Fig. 9, a bottom contacting surface 222 of the integrated circuit package is facing the lead frame 230. A top contacting surface 212 of the integrated circuit package is facing the permanent magnet, which is not shown in Fig. 9.

The top contacting surface 212 comprises a first contact arrangement 214 and the bottom contacting surface 222 comprises a second contact arrangement 224. The first contact arrangement 214 is contacted by a first technique, preferably by wire bonding using e.g. gold wires 216, to the lead frame 230. The second contact arrangement 224 is contacted by a second technique, preferably by flip chip using e.g. solder 226 comprising Sn, to lead frame 230. Such an arrangement is particularly advantages for a compact design of the integrated circuit package by maximizing the distance between the sensing planes, which are comprised in the contacting surfaces 212 and 222.

Fig. 10 shows a schematic view of an integrated circuit package 500 according to an alternative embodiment. The integrated circuit package 500 comprises a lead frame 230, a first die comprising the first sensing element 210, and a second die comprising the second sensing element 220. The integrated circuit package 500 is covered by a housing 510.

Advantageously, the integrated circuit package 500 additionally houses a processor, which is not shown in Figs. 9 and 10. As discussed above, the processor computes the magnetic stray field by comparing the first field strength computed based on data measured by the first sensing element with the second field strength computed based on data measured by the second sensing element.

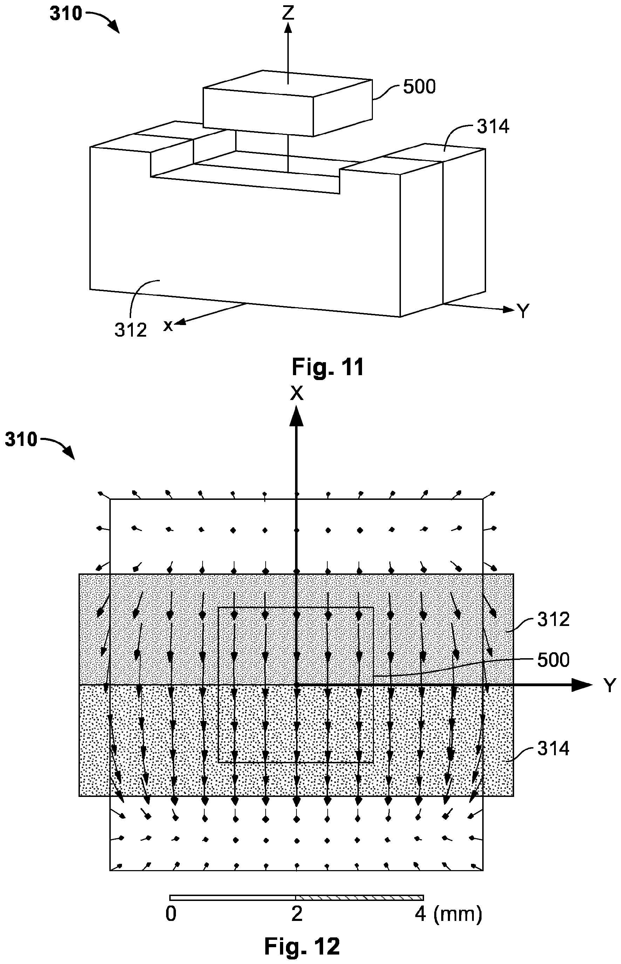

Fig. 11 shows of a schematic side view of a permanent magnet 310 and a sensing element, e.g. an integrated circuit package 500, forming partly the assembly. Fig. 12 shows bottom view of Fig. 11.

According to this embodiment, the permanent magnet 310 has a U-shape. The open part of the U-shaped magnet 310 is facing the integrated circuit package 500. The arms of the U-shaped permanent magnet 310 are extending in the direction z, namely towards the integrated circuit package 500. The element interconnecting the arms is extending in the direction of y, namely parallel to the integrated circuit package 500. The magnetic south pole 312 and the opposing magnetic north pole 314 are formed by surfaces extending in z-y direction. According to this embodiment, the axis z is the axis of rotation.

The arrows over-plotted in Fig. 12 indicate the vectors of the magnetic field generated by the permanent magnet 310 in the plane of the integrated circuit package 500. In particular, the U-shaped permanent magnet 310 with poles 312 and 340 optimizes that the field vectors of the magnetic field components in sensor plane can be assumed to be parallel within the dimensions of the integrated circuit package 500.

Although the above aspects for the assembly have been described separately, each combination enables a synergetic effect. In particular, each combination of a small sized sensor, e.g. by the advantage embodiments disclosed with reference to Fig. 3 to 5, an optimized packaging, e.g. disclosed by the advantage embodiments shown with reference to figures 9 and 10, and an optimized magnet, e.g. by the advantage embodiment disclosed in figures 11 and 10, enables a synergetic effect. In particular, the synergetic effects are a small volume magnet that can be used for generating a parallel magnetic field perpendicular to the axis of rotation in the sensor plane having a high divergence in the direction of the axis of rotation across the assembly.

Exemplary calculations for one embodiment with a magnetic field of H0 =25kA/m and Hcoil= 1 kA/m show the fact, that the output voltage changes depending on the field angle ω (°) with a 360°-periodicity. Therefore such assemblies, even when built in AMR-Technology with its 180°-periodicity, are able to detect field angles in the full 360°-range. Another important property of such an AMR-technology system is that there is no angle where more than one signal shows no coil field dependency. Therefore the three signal-change values contain in each angular position enough information to detect the field angle, especially the decision between 0-180 and 180-360°-range, as well as the total amplitude of these signal change curves. The total amplitude of the signal change curves together with the actual signal amplitude itself and the known coil field allows the calculation of the strength of the magnetic field at the sensor position. The output signals are averaged over both coil current directions. This allows a high accuracy angular detection of the field at the sensor position.

According to a further embodiment, not shown in the figures, the magneto resistive layers arranged in a sensor plane with different resistance changes in the magnetic field may be realized by an angle between the resistor greater than 0° and less than 180°.

### REFERENCE NUMERALS

| **Reference Numeral** | **Description** |
|---|---|
| 100 | assembly |
| 200 | magnetic sensor |
| 210 | first magnetic sensing element |
| 212 | top contacting surface |
| 214 | first contact arrangement |
| 216 | bond wires |
| 220 | second magnetic sensing element |
| 222 | bottom contacting surface |
| 224 | second contact arrangement |
| 226 | connection between sensor pads and leadframe |
| 230 | circuit board |
| 240 | integrated circuit |
| 250 | sensing element |
| 251, 253 | resistor |
| 252, 254, 256 | voltage divider |
| 260 | Coil |
| 262, 264 | contacting nodes |
| 300 | rotary member |
| 310 | permanent magnet |
| 312 | magnetic south pole |
| 314 | magnetic north pole |
| 320 | rotating shaft |
| 330 | arrow indicating axis of rotation |
| 400 | diagram indicating magnetic field H0 |
| 500 | integrated circuit package |
| 510 | insulating mold material |

## Claims

1. An assembly (100) for determining the influence of an external disturbing magnetic field (HD) in a magnetic sensor (200) detecting a rotational angle (ω) of a rotary member (300), the assembly (100) comprising:
a permanent magnet (310) for generating a magnetic field (H0), the permanent magnet (310) being arranged on the rotary member (300) so that the magnetic poles (312, 314) generate a magnetic field perpendicular to the axis at the magnetic sensor about which the rotary member (300) rotates;
a first channel comprising a first magnetic sensing element (210) centered on the axis of rotation, the first channel configured to provide first angular data;
a second channel comprising a second magnetic sensing element (220) centered on the axis of rotation, the second channel configured to provide second angular data,
wherein the second magnetic sensing element (220) is spaced in the direction of the axis of rotation by a predetermined value z from the first magnetic sensing element (210);
**characterized in that** the assembly (100) furthermore comprises
an induction channel comprising an electromagnetic coil (260) wound around the axis of rotation, the induction channel being adapted to pass an electric current (Icoil+, Icoil-), the electromagnetic coil (260) for generating a magnetic field (Hcoil) induced in a plane of the first magnetic sensing element (210) and in a plane of the second magnetic sensing element, wherein the magnetic field (Hcoil) is partially orthogonal to the magnetic field generated by the permanent magnet in the plane of the first magnetic sensing element and the plane of the second magnetic sensing element;
a processor configured to:
compute a first field strength based on a plurality of first angular data received by the first channel, wherein the plurality of first angular data is detected with a first value (Icoil+) of the electric current passed through the induction channel for generating a first excitation field and is detected with a second value (Icoil-) of the electric current passed through the induction channel for generating a second excitation field, the first excitation field is different from the second excitation field;
compute a second field strength based on a plurality of second angular data received by the second channel, wherein the plurality of second angular data is detected with a third value (Icoil+) of the electric current passed through the induction channel for generating a third excitation field and is detected with a fourth value (Icoil-) of the electric current passed through the induction channel for generating a fourth excitation field, the fourth excitation field is different from the third excitation field;
compute the magnetic stray field component orthogonal to the magnetic field (H0) by comparing the first field strength with the second field strength;
wherein each of the first magnetic sensing element (210) and the second magnetic sensing element (220) comprises three voltage divider (252, 254, 256).

2. The assembly (100) according to claim 1 or 2, wherein each voltage divider (252, 254, 256) comprises resistors (251, 253) formed by magneto resistive layers arranged in a sensor plane with opposing resistance changes in the magnetic field.

3. The assembly according to claim 2, wherein each voltage divider (252, 254, 256) comprises a first conducting path forming a first resistor (251) and a second conducting path arranged perpendicular to the first conducting path and forming a second resistor (253).

4. The assembly (100) according to one of the claims 1 to 3, wherein the windings of the electromagnetic coil (260) form triangles.

5. The assembly (100) according to one of the claims 1 to 4, wherein a first electromagnetic coil and the first magnetic sensing element (210) are fabricated as an integrated circuit forming a first die and wherein a second electromagnetic coil and the second magnetic sensing element (220) are fabricated as an integrated circuit forming a second die.

6. The assembly (100) according to claim 5, wherein the second die is stacked atop the first die, packaged together in an integrated circuit package (500).

7. The assembly (100) according to claim 6, wherein a top contacting surface (212) of the integrated circuit package (500) is facing the permanent magnet (310) and wherein a bottom contacting surface (222) of the integrated circuit package (500) is facing a circuit board (230).

8. The assembly (100) according to claim 6 or 7, wherein the circuit board is a lead frame (230) and a first contact arrangement (214) of the first magnetic sensing element in the integrated circuit package (500) is contacted to the lead frame (230) by a first technique, preferably by wire bonding, and a second contact arrangement (224) of the second magnetic sensing element in the integrated circuit package (500) is contacted by a second technique, preferably by connecting in flip chip technology.

9. The assembly (100) according to claim 8, wherein the integrated circuit package (500), the lead frame and the processor are covered by a common housing (510).

10. The assembly (100) according to one of the claims 1 to 9, wherein the permanent magnet (310) has a short side and a long side, wherein the long side is longer than the short side, preferably the long side is 2 to 20 times longer than the short side.

11. The assembly (100) according to one of the claim 10, wherein the poles (312, 314) of the permanent magnet, preferably comprising rare earth materials, are formed at opposite ends of the short side.

12. The assembly (100) according to claim 10 or 11, wherein the permanent magnet (310) has a recess at a surface facing the first magnetic sensing element, and/or
wherein the permanent magnet has a north- and a south pole, which are located on the side of the magnet facing the sensor on both sides of the axis of rotation.

13. A method for sensing the strength of a magnetic stray field (HD) in a magnetic sensor detecting a rotational angle of a rotary member with an assembly according to one of the claims 1 to 12,
computing, by a processor, a first field strength based on a plurality of first angular data received by a first channel, wherein the plurality of first angular data is detected with a first value (Icoil+) of an electric current passed through an induction channel for generating a first excitation field and is detected with a second value (Icoil-) of the electric current passed through the induction channel for generating a second excitation field, the first excitation field is different from the second excitation field,
computing, by the processor, a second field strength based on a plurality of second angular data received by a second channel, wherein the plurality of second angular data is detected with a third value (Icoil+) of the electric current passed through the induction channel for generating a third excitation field and is detected with a fourth value (Icoil-) of the electric current passed through the induction channel for generating a fourth excitation field, the fourth excitation field is different from the third excitation field,
computing, by the processor, the magnetic stray field (HD) by comparing the first field strength with the second field strength.

14. The method according to claim 13, wherein the first field strength is computed by passing two different values (Icoil+, Icoil-) of the electric current through the induction channel and receiving two first angular data for the two different values (Icoil+, Icoil-) of the electric current, respectively; and
wherein the second field strength is computed by passing two different values (Icoil+, Icoil-) of the electric current through the induction channel and receiving two second angular data for the two different values (Icoil+, Icoil-) of the electric current, respectively.

15. The method according to claim 13 or 14, wherein based on the angular information and the information about the field strength of the field at both sensors an undisturbed angular value is calculated, wherein the undisturbed angular value is equal to a magnetic field angle that is not disturbed by external disturbing fields.

## Patentansprüche

1. Baugruppe (100) zum Bestimmen des Einflusses eines äußeren störenden Magnetfeldes (HD) in einem Magnetsensor (200), der einen Drehwinkel (ω) eines Drehelementes (300) erfasst, wobei die Baugruppe (100) umfasst:
einen Permanentmagneten (310) zum Erzeugen eines Magnetfeldes (H0), wobei der Permanentmagnet (310) an dem Drehelement (300) so angeordnet ist, dass die Magnetpole (312, 314) ein Magnetfeld senkrecht zu der Achse an dem Magnetsensor erzeugen, um die sich das Drehelement (300) dreht;
einen ersten Kanal, der ein erstes magnetisches Sensorelement (210) umfasst, das auf die Drehachse zentriert ist, wobei der erste Kanal so konfiguriert ist, dass er erste Winkeldaten liefert;
einen zweiten Kanal, der ein zweites magnetisches Sensorelement (220) umfasst, das auf die Drehachse zentriert ist, wobei der zweite Kanal so konfiguriert ist, dass er zweite Winkeldaten liefert, und das zweite magnetische Sensorelement (220) in der Richtung der Drehachse um einen vorgegebenen Wert z von dem ersten magnetischen Sensorelement (210) beabstandet ist;
**dadurch gekennzeichnet, dass** die Baugruppe (100) des Weiteren umfasst:
einen Induktions-Kanal, der eine elektromagnetische Spule (260) umfasst, die um die Drehachse herum gewickelt ist, wobei der Induktions-Kanal so eingerichtet ist, dass er einen elektrischen Strom (Icoil+, Icoil-) leitet und die elektromagnetische Spule (260) dazu dient, ein Magnetfeld (Hcoil) zu erzeugen, das in einer Ebene des ersten magnetischen Sensorelementes (210) und in einer Ebene des zweiten magnetischen Sensorelementes (210) induziert wird, wobei das Magnetfeld (Hcoil) teilweise orthogonal zu dem Magnetfeld ist, das durch den Permanentmagneten in der Ebene des ersten magnetischen Sensorelementes und der Ebene des zweiten magnetischen Sensorelementes erzeugt wird;
einen Prozessor, der so konfiguriert ist, dass er durchführt:
Berechnen einer ersten Feldstärke auf Basis einer Vielzahl über den ersten Kanal empfangener erster Winkeldaten, wobei die Vielzahl erster Winkeldaten mit einem ersten Wert (Icoil+) des durch den Induktions-Kanal geleiteten elektrischen Stroms zum Erzeugen eines ersten Erregungsfeldes erfasst wird, und mit einem zweiten Wert (Icoil-) des durch den Induktions-Kanal geleiteten elektrischen Stroms zum Erzeugen eines zweiten Erregungsfeldes erfasst wird, wobei sich das erste Erregungsfeld von dem zweiten Erregungsfeld unterscheidet;
Berechnen einer zweiten Feldstärke auf Basis einer Vielzahl über den zweiten Kanal empfangener zweiter Winkeldaten, wobei die Vielzahl zweiter Winkeldaten mit einem dritten Wert (Icoil+) des durch den Induktions-Kanal geleiteten elektrischen Stroms zum Erzeugen eines dritten Erregungsfeldes erfasst wird, und mit einem vierten Wert (Icoil-) des durch den Induktions-Kanal geleiteten elektrischen Stroms zum Erzeugen eines vierten Erregungsfeldes erfasst wird, wobei sich das vierte Erregungsfeld von dem dritten Erregungsfeld unterscheidet;
Berechnen der magnetischen Streufeld-Komponente orthogonal zu dem Magnetfeld (H0) durch Vergleichen der ersten Feldstärke mit der zweiten Feldstärke;
wobei sowohl das erste magnetische Sensorelement (210) als auch das zweite magnetische Sensorelement (220e) drei Spannungsteiler (252, 254, 256) umfasst.

2. Baugruppe (100) nach Anspruch 1 oder 2, wobei jeder Spannungsteiler (252, 254, 256) Widerstände (251, 253) umfasst, die durch in einer Sensor-Ebene angeordnete magnetoresistive Schichten mit entgegengesetzten Widerstandsänderungen in dem Magnetfeld gebildet werden.

3. Baugruppe nach Anspruch 2, wobei jeder Spannungsteiler (252, 254, 256) einen ersten leitenden Weg, der einen ersten Widerstand (251) bildet, und einen zweiten leitenden Weg umfasst, der senkrecht zu dem ersten leitenden Weg angeordnet ist und einen zweiten Widerstand (253) bildet.

4. Baugruppe (100) nach einem der Ansprüche 1 bis 3, wobei die Wicklungen der elektromagnetischen Spule (260) Dreiecke bilden.

5. Baugruppe (100) nach einem der Ansprüche 1 bis 4, wobei eine erste elektromagnetische Spule sowie das erste magnetische Sensorelement (210) als eine integrierte Schaltung hergestellt werden, die einen ersten Chip bildet, und eine zweite elektromagnetische Spule sowie das zweite magnetische Sensorelement (220) als eine integrierte Schaltung hergestellt werden, die einen zweiten Chip bildet.

6. Baugruppe (100) nach Anspruch 5, wobei der zweite Chip über den ersten Chip geschichtet ist und sie zusammen zu einem integrierten Schaltungsbaustein (500) montiert sind.

7. Baugruppe (100) nach Anspruch 6, wobei eine obere Kontaktfläche (212) des integrierten Schaltungsbausteins (500) dem Permanentmagneten (310) zugewandt ist und eine untere Kontaktfläche (222) des integrierten Schaltungsbausteins (500) einer Leiterplatte (230) zugewandt ist.

8. Baugruppe (100) nach Anspruch 6 oder 7, wobei die Leiterplatte ein Leiterrahmen (230) ist und eine erste Kontaktanordnung (214) des ersten magnetischen Sensorelementes in dem integrierten Schaltungsbaustein (500) mit dem Leiterrahmen (230) mittels einer ersten Technik, vorzugsweise mittels Drahtbonden, kontaktiert wird,
und eine zweite Kontaktanordnung (224) des zweiten magnetischen Sensorelementes in dem integrierten Schaltungsbaustein (500) mittels einer zweiten Technik, vorzugsweise mittels Verbinden in Flip-Chip-Technik, kontaktiert wird.

9. Baugruppe (100) nach Anspruch 8, wobei der integrierte Schaltungsbaustein (500), der Leiterrahmen und der Prozessor von einem gemeinsamen Gehäuse (510) abgedeckt werden.

10. Baugruppe (100) nach einem der Ansprüche 1 bis 9, wobei der Permanentmagnet (310) eine kurze Seite und eine lange Seite hat, die lange Seite länger ist als die kurze Seite und vorzugsweise die lange Seite 2- bis 20-mal länger ist als die kurze Seite.

11. Baugruppe (100) nach Anspruch 10, wobei die Pole (312, 314) des Permanentmagneten, die vorzugsweise Seltenerd-Materialien umfassen, an gegenüberliegenden Enden der kurzen Seite ausgebildet sind.

12. Baugruppe (100) nach Anspruch 10 oder 11, wobei der Permanentmagnet (310) an einer dem ersten magnetischen Sensorelement zugewandten Fläche eine Vertiefung aufweist, und/oder
der Permanentmagnet einen Nord- und einen Südpol hat, die sich an der dem Sensor zugewandten Seite des Magneten an beiden Seiten der Drehachse befinden.

13. Verfahren zum Erfassen der Stärke eines magnetischen Streufeldes (HD) in einem Magnetsensor, der einen Drehwinkel eines Drehelementes mit einer Baugruppe nach einem der Ansprüche 1 bis 12 erfasst,
mittels eines Prozessors eine erste Feldstärke auf Basis einer Vielzahl erster Winkeldaten berechnet, die über einen ersten Kanal empfangen werden, wobei die Vielzahl erster Winkeldaten mit einem ersten Wert (Icoil+) eines durch einen Induktions-Kanal geleiteten elektrischen Stroms zum Erzeugen eines ersten Erregungsfeldes erfasst wird, und mit einem zweiten Wert (Icoil-) des durch den Induktions-Kanal geleiteten elektrischen Stroms zum Erzeugen eines zweiten Erregungsfeldes erfasst wird, wobei sich das erste Erregungsfeld von dem zweiten Erregungsfeld unterscheidet;
mittels des Prozessors eine zweite Feldstärke auf Basis einer Vielzahl zweiter Winkeldaten berechnet, die über einen zweiten Kanal empfangen werden, wobei die Vielzahl zweiter Winkeldaten mit einem dritten Wert (Icoil+) des durch den Induktions-Kanal geleiteten elektrischen Stroms zum Erzeugen eines dritten Erregungsfeldes erfasst wird, und mit einem vierten Wert (Icoil-) des durch den Induktions-Kanal geleiteten elektrischen Stroms zum Erzeugen eines vierten Erregungsfeldes erfasst wird, wobei sich das vierte Erregungsfeld von dem dritten Erregungsfeld unterscheidet;
mittels des Prozessors das magnetische Streufeld (HD) durch Vergleichen der ersten Feldstärke mit der zweiten Feldstärke berechnet.

14. Verfahren nach Anspruch 13, wobei die erste Feldstärke berechnet wird, indem zwei verschiedene Werte (Icoil+, Icoil-) des elektrischen Stroms durch den Induktions-Kanal geleitet werden und jeweils zwei erste Winkeldatenelemente für die zwei verschiedenen Werte (Icoil+, Icoil-) des elektrischen Stroms empfangen werden; und
die zweite Feldstärke berechnet wird, indem zwei verschiedene Werte (Icoil+, Icoil-) des elektrischen Stroms durch den Induktions-Kanal geleitet werden und jeweils zwei zweite Winkeldatenelemente für die zwei verschiedenen Werte (Icoil+, Icoil-) des elektrischen Stroms empfangen werden.

15. Verfahren nach Anspruch 13 oder 14, wobei auf Basis der Winkel-Informationen sowie der Informationen über die Feldstärke des Feldes an beiden Sensoren ein ungestörter Winkelwert berechnet wird, und der ungestörte Winkelwert einem Magnetfeldwinkel gleich ist, der nicht durch äußere Störfelder gestört wird.

## Revendications

1. Assemblage (100) pour déterminer l'influence d'un champ magnétique parasite externe (HD) dans un capteur magnétique (200) détectant un angle de rotation (ω) d'un élément rotatif (300), l'assemblage (100) comprenant :
un aimant permanent (310) pour générer un champ magnétique (H0), l'aimant permanent (310) étant disposé sur l'élément rotatif (300) de sorte que les pôles magnétiques (312, 314) génèrent un champ magnétique perpendiculaire à l'axe au niveau du capteur magnétique autour duquel l'élément rotatif (300) tourne ;
un premier canal comprenant un premier élément de détection magnétique (210) centré sur l'axe de rotation, le premier canal configuré pour fournir de premières données angulaires ;
un deuxième canal comprenant un deuxième élément de détection magnétique (220) centré sur l'axe de rotation, le deuxième canal configuré pour fournir des deuxièmes données angulaires, dans lequel le deuxième élément de détection magnétique (220) est espacé dans la direction de l'axe de rotation par une valeur prédéterminée z du premier élément de détection magnétique (210) ;
**caractérisé en ce que** l'assemblage (100) comprend en outre
un canal d'induction comprenant une bobine électromagnétique (260) enroulée autour de l'axe de rotation, le canal d'induction étant adapté pour faire passer un courant électrique (Icoil+, Icoil-), la bobine électromagnétique (260) pour générer un champ magnétique (Hcoil) induit dans un plan du premier élément de détection magnétique (210) et dans un plan du deuxième élément de détection magnétique, dans lequel le champ magnétique (Hcoil) est partiellement orthogonal au champ magnétique généré par l'aimant permanent dans le plan du premier élément de détection magnétique et le plan du deuxième élément de détection magnétique ;
un processeur configuré pour :
calculer une première force de champ selon une pluralité de premières données angulaires reçue par le premier canal, dans lequel la pluralité de premières données angulaires est détectée avec une première valeur (Icoil+) du courant électrique passé à travers le canal d'induction pour générer un premier champ d'excitation et est détectée avec une deuxième valeur (Icoil-) du courant électrique passé à travers le canal d'induction pour générer un deuxième champ d'excitation, le premier champ d'excitation est différent du deuxième champ d'excitation ;
calculer une deuxième force de champ selon une pluralité de deuxièmes données angulaires reçue par le deuxième canal, dans lequel la pluralité de deuxièmes données angulaires est détectée avec une troisième valeur (Icoil+) du courant électrique passé à travers le canal d'induction pour générer un troisième champ d'excitation et est détectée avec une quatrième valeur (Icoil-) du courant électrique passé à travers le canal d'induction pour générer un quatrième champ d'excitation, le quatrième champ d'excitation est différent du troisième champ d'excitation ;
calculer le composant de champ magnétique parasite orthogonal au champ magnétique (H0) en comparant la première force de champ à la deuxième force de champ ;
dans lequel chacun du premier élément de détection magnétique (210) et du deuxième élément de détection magnétique (220) comprend trois diviseurs de tension (252, 254, 256).

2. L'assemblage (100) selon la revendication 1 ou 2, dans lequel chaque diviseur de tension (252, 254, 256) comprend des résistances (251, 253) constituées par des couches magnétorésistives disposées dans un plan de capteur avec des changements de résistances opposées dans le champ magnétique.

3. L'assemblage selon la revendication 2, dans lequel chaque diviseur de tension (252, 254, 256) comprend un premier chemin de conduction constituant une première résistance (251) et un deuxième chemin de conduction disposé perpendiculaire au premier chemin de conduction et constituant une deuxième résistance (253).

4. L'assemblage (100) selon l'une des revendications 1 à 3, dans lequel les bobinages de la bobine électromagnétique (260) forment des triangles.

5. L'assemblage (100) selon l'une des revendications 1 à 4, dans lequel une première bobine électromagnétique et le premier élément de détection magnétique (210) sont fabriqués comme un circuit intégré constituant une première matrice et dans lequel une deuxième bobine électromagnétique et le deuxième élément de détection magnétique (220) sont fabriqués comme un circuit intégré constituant une deuxième matrice.

6. L'assemblage (100) selon la revendication 5, dans lequel la deuxième matrice est empilée sur la première matrice, conditionnées ensemble dans un boîtier de circuit intégré (500).

7. L'assemblage (100) selon la revendication 6, dans lequel une surface de contact sommitale (212) du boîtier de circuit intégré (500) est orientée vers l'aimant permanent (310) et dans lequel une surface de contact de fond (222) du boîtier de circuit intégré (500) est orientée vers une carte de circuits (230).

8. L'assemblage (100) selon la revendication 6 ou 7, dans lequel la carte de circuit est une grille de connexion (230) et une première disposition de contact (214) du premier élément de détection magnétique dans le boîtier de circuit intégré (500) est en contact avec la grille de connexion (230) par une première technique, de préférence par câblage filaire, et une deuxième disposition de contact (224) du deuxième élément de détection magnétique dans le boîtier de circuit intégré (500) est en contact par une deuxième technique, de préférence par connexion en technologie de puce inversée (flip chip).

9. L'assemblage (100) selon la revendication 8, dans lequel le boîtier de circuit intégré (500), la grille de connexion et le processeur sont couverts par un boîtier commun (510).

10. L'assemblage (100) selon l'une des revendications 1 à 9, dans lequel l'aimant permanent (310) présente un côté court et un côté long, dans lequel le côté long est plus long que le côté court, de préférence le côté long est 2 à 20 fois plus long que le côté court.

11. L'assemblage (100) selon l'une de la revendication 10, dans lequel les pôles (312, 314) de l'aimant permanent, de préférence comprenant des matériaux de terres rares, sont formés à des extrémités opposées du côté court.

12. L'assemblage (100) selon la revendication 10 ou 11, dans lequel l'aimant permanent (310) présente une cavité sur une surface orientée vers le premier élément de détection magnétique, et/ou
dans lequel l'aimant permanent présente un pôle nord et un pôle sud, qui sont situés sur le côté de l'aimant orienté vers le capteur sur les deux côtés de l'axe de rotation.

13. Procédé de détection de la force d'un champ magnétique parasite (HD) dans un capteur magnétique détectant un angle de rotation de l'élément rotatif avec un assemblage selon l'une des revendications 1 à 12,
calcul, par un processeur, d'une première force de champ selon une pluralité de premières données angulaires reçue par un premier canal, dans lequel la pluralité de premières données angulaires est détectée avec une première valeur (Icoil+) d'un courant électrique passé à travers un canal d'induction pour générer un premier champ d'excitation et est détectée avec une deuxième valeur (Icoil-) du courant électrique passé à travers le canal d'induction pour générer un deuxième champ d'excitation, le premier champ d'excitation est différent du deuxième champ d'excitation,
calcul, par le processeur, d'une deuxième force de champ selon une pluralité de deuxièmes données angulaires reçue par un deuxième canal, dans lequel la pluralité de deuxièmes données angulaires est détectée avec une troisième valeur (Icoil+) du courant électrique passé à travers le canal d'induction pour générer un troisième champ d'excitation et est détectée avec une quatrième valeur (Icoil-) du courant électrique passé à travers le canal d'induction pour générer un quatrième champ d'excitation, le quatrième champ d'excitation est différent du troisième champ d'excitation,
calcul, par le processeur, du champ magnétique parasite (HD) en comparant la première force de champ et la deuxième force de champ.

14. Le procédé selon la revendication 13, dans lequel la première force de champ est calculée en passant deux valeurs différentes (Icoil+, Icoil-) du courant électrique à travers le canal d'induction et en recevant deux premières données angulaires pour les deux valeurs différentes (Icoil+, Icoil-) du courant électrique, respectivement ; et
dans lequel la deuxième force de champ est calculée en passant deux valeurs différentes (Icoil+, Icoil-) du courant électrique à travers le canal d'induction et en recevant deux deuxièmes données angulaires pour les deux valeurs différentes (Icoil+, Icoil-) du courant électrique, respectivement.

15. Le procédé selon la revendication 13 ou 14, dans lequel selon les informations angulaires et les informations relatives à la force de champ du champ au niveau des deux capteurs une valeur angulaire non perturbée est calculée, dans lequel la valeur angulaire non perturbée est égale à un angle de champ magnétique qui n'est pas perturbé par des champs perturbateurs externes.
